# EUROPEAN PATENT APPLICATION

(11) **EP 2 642 543 A1**
(43) Date of publication of application: **25.09.2013**
(21) Application number: 13153997.5
(22) Date of filing: 05.02.2013
(51) Int. Cl.: H01L 39/14, H01B 12/16, H01L 39/24, H01F 6/04

(54) **MGB2 superconducting multi-core wires, superconducting cables, and superconducting magnets**

(30) Priority: 23.03.2012 JP 2012066502
(71) Applicant: Hitachi Ltd., Tokyo 100-8280 (JP)
(72) Inventor: Tanaka, Kazuhide, Tokyo 100-8220 (JP); Kodama, Motomune, Tokyo 100-8220 (JP); Ichiki, Yota, Tokyo 100-8220 (JP)
(74) Representative: MERH-IP Matias Erny Reichl Hoffmann

(57) **Abstract**

The present invention provides a MgB₂ multi-core wire (1) comprising a plurality of MgB₂ single-core wires (2) having a MgB₂ superconducting core part (3) and a metal sheath part, the metal sheath part being provided on the outer surface of the MgB₂ superconducting core part (3), wherein a plurality of the MgB₂ single-core wires (2) is bound with each other, and a gap (6) is provided between a plurality of the MgB₂ single-core wires (2), and a refrigerant is flown in the gap (6) in a direction of a longitudinal axis of the MgB₂ single-core wires (2).

## Description

### BACKGROUND OF THE INVENTION

### 1. Field of the Invention

The present invention relates MgB₂ superconducting multi-core wires, superconducting cables, and superconducting magnets.

It was discovered that MgB₂ exhibits superconducting properties at 39 K in the 21st century. The following features are mainly known as the properties of this material.
(1) The critical temperature (Tc) is 39 K. This temperature is higher than the critical temperature of a related art metal superconductor by 20 K or more.
(2) The problems about weak coupling and large magnetization relaxation, which significantly appear in a copper oxide superconductor, are small.
(3) There are abundant MgB₂ resources, it can be obtained relatively at low cost, and the mechanical strength of the material is high.
(4) The magnetic anisotropy is small, and an equal current can be made to flow in any directions of a-axis, b-axis and c-axis of the crystal.
(5) The Tc and the upper critical magnetic field (hereinafter referred to Hc2) are higher than those of the related art metal superconductor.

From these features, when MgB₂ superconductor is applied to a magnet, a system whose quench accidents are rare, can be configured. MgB₂ superconductor is expected as the superconducting material which implements a highly stable superconducting magnet.

In practical superconducting wires, a plurality of single-core wires is incorporated so as to form multiple cores, in terms of the increase of the thermal stability and the reduction of the alternating current loss. Patent document 1 discloses that multi-core wire is produced by a multi-core embedding procedure. The multi-core embedding procedure is that a plurality of single-core wires which are covered by Fe, Nb, or Ta is bound, and the bound wire is embedded to the pipe made of Cu or the like whose electric resistance are small.

[Patent document 1] JP-A-2004-319107

However, in the wire procured by the multi-core embedding procedure, semiconducting single-core wire (filament) always sticks the metal which is Cu or the like. Therefore, there is a problem that in the case of cooling superconducting cables and superconducting magnets by using refrigerants which is liquid helium, liquid hydrogen or the like, the cooling efficiency is poor. The object of the present invention is to increase the cooling efficiency when cooling multi-core wires by using refrigerants.

### SUMMARY OF THE INVENTION

To solve the above problem, the present invention provides a MgB₂ multi-core wire (1) comprising a plurality of MgB₂ single-core wires (2) having a MgB₂ superconducting core part (3) and a metal sheath part, the metal sheath part being provided on the outer surface of the MgB₂ superconducting core part (3), wherein a plurality of the MgB₂ single-core wires (2) is bound with each other, and a gap (6) is provided between a plurality of the MgB₂ single-core wires (2), and a refrigerant is flown in the gap (6) in a direction of a longitudinal axis of the MgB₂ single-core wires (2).

The present invention increases the cooling efficiency when cooling multi-core wires by using refrigerants.

### BRIEF DESCRIPTION OF the Drawings

FIG. 1 is a flow chart of the way of producing a MgB₂ superconducting multi-core wire.
FIG. 2 is a schematic diagram of the way of producing a MgB₂ superconducting multi-core wire.
FIG. 3 is a cross section schematic diagram illustrating an example of the section structure of a MgB₂ superconducting multi-core wire.
FIG. 4 is a cross section schematic diagram illustrating another example of the section structure of a MgB₂ superconducting multi-core wire.
FIG. 5 is a cross section schematic diagram of a MgB₂ superconducting multi-core wire produced by the multi-core embedding procedure as a comparative example in the present invention.
FIG. 6 is a structure diagram of a superconducting magnet.

### DETAILED DESCRIPTION OF THE PREFERRED EMBODIMENTS

The embodiments according to the present invention are discussed below with reference to the drawings to explain the present invention in detail. The present invention is not limited to the following content, but can be arbitrarily combined and modified within the scope not departing from the gist of the present invention.

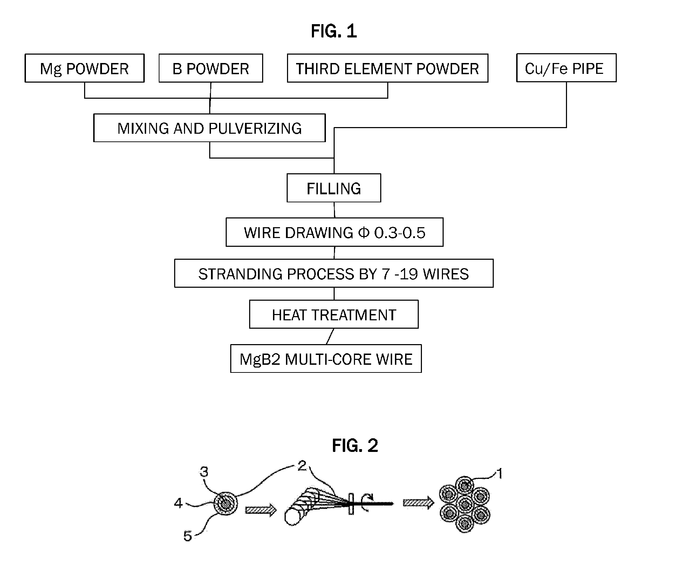

FIG. 1 illustrates a flow chart of the way of producing an MgB₂ superconducting multi-core wire. Firstly, after the weight of Mg powder, the weight of B powder, and the weight of third element powder (for example, B₄C powder) depending on the situation as the raw material are measured, they are pulverized and mixed by ball mill or the like. The obtained powder is filled in Cu/Fe compound sheath pipe including two layers of an outer copper layer and an inside iron layer, and wire drawing is performed until the diameter of the wire becomes about 0.3 mm to 0.5 mm. From 7 to 19 wires are produced, and they become a multi-core wire by giving stranding process. After that, the multi-core wire is subjected to a heat treatment at 580 °C to 850 °C degree for from 30 minutes to several tens of hours, and a superconducting multi-core wire is obtained.

FIG. 2 illustrates easily the way of producing the MgB₂ superconducting multi-core wire in the present invention. A single-core wire 2 is subjected to the wire drawing until the final diameter becomes about 0.5 mm, and a multi-core wire 1 is formed by binding a plurality of the single-core wires 2 by twisting machine and becoming a conductor. The single-core wire 2 comprises a superconducting core part 3 and a metal sheath part which is provided on the outer surface of the superconducting core part 3. The metal sheath part comprises a barrier phase 4 and a stabilization phase 5 which is provided on the outer surface of the barrier phase 4.

The sectional shape of the single-core wire 2 is circular or polygon, and the metal sheath parts in the single-core wires 2 contact in point-to-point or in plane-to-plane each other in the radial direction. A gap 6 is formed between the single-core wires 2 each other by binding a plurality of the single-core wires 2. Conventionally, the gap 6 was filled in the metal to increase current path, but in the present invention, the pipe in a direction of a longitudinal axis of the single-core wire 2 is formed between the single-core wires 2 by using the barrier phase 4 as a wall. At this time, the size of the gap 6 is from several µm to 10 µm, and the gap 6 becomes refrigerant duct. The cooling efficiency of multi-core wire 1 increases because not only the outside of the multi-core wire 1 but the inside of the multi-core wire 1 can be cooled by flowing of the refrigerant inside of the multi-core wire 1, that is, between the single-core wires 2.

As stated above, the wire is produced by a PIT method as an example in which a powder is filled in a pipe metal sheath material and plastic working is performed, but a rod-in-tube method may be adopted in which a pressed powder compact obtained by molding a powder is filled in a pipe metal sheath material and plastic working is performed.

Examples of the wire drawing to reduce the diameter of the wire include drawbench, hydrostatic extrusion, swage, cassette roller dice, and groove roll, and the wire drawing is repeated so that cross section reduction ratio per one pass is about 8 % to 12 %. Generally, a plurality of single-core wires, which is subjected to the wire drawing to make into the circular cross section shape or rectangular cross section shape, is twisted together so as to form multiple cores.

The heat treatment is performed at the lowest possible temperature and for the shortest possible time. By this, the number of crystal grain boundaries effective as pinning centers can be increased. To enhance the pinning effect, that is, to suppress the reduction of Jc in a magnetic field has a great effect in the application to superconducting magnets which operate in a middle magnetic field and a high magnetic field.

It is effective to add the third element to increase Jc. For example, Jc in the magnetic field is particularly increased by adding BC or SiC which is a powder containing C. This is no limited to the manufacturing method of MgB₂, the same effect can be achieved by in-situ method, ex-situ method, or premix method.

### Example 1

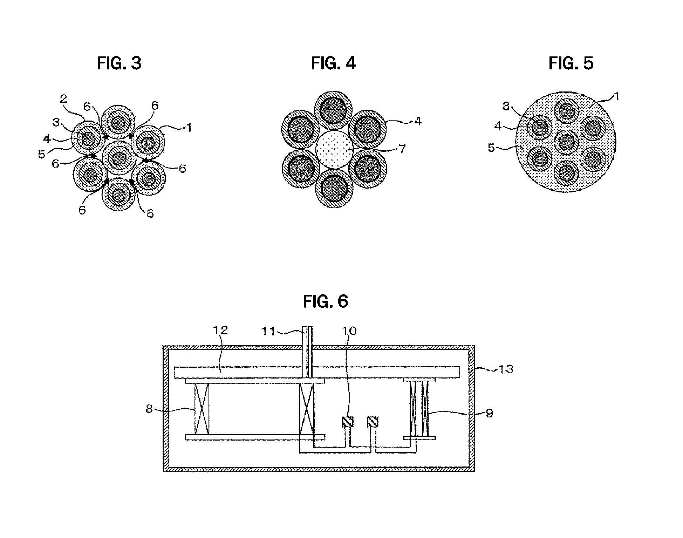

FIG. 3 is a cross section schematic diagram illustrating an example of the section structure of an MgB₂ superconducting multi-core wire in one embodiment. As illustrated in FIG. 3, the multi-core wire 1 is configured to be twisted together a plurality of the single-core wires 2. Now, the gap 6 is formed inside a plurality of the single-core wires 2 by a plurality of the single-core wires 2. A refrigerant can be flown in the gap 6.

In FIG. 3, the barrier phase 4 in the metal sheath part was made of iron, but the barrier phase 4 may be made of niobium, tantalum, and nickel. Also, the stabilization phase 5 is made of copper or copper alloy. The stabilization phase 5 may be made of aluminum or aluminum alloy as necessary.

Hereinafter, a manufacturing process in one embodiment will be described.

### <Manufacturing process of the single-core wire>

The weight of magnesium powder (Mg purity: 97% or more) having an average grain size of 45 µm and the weight of boron powder (B purity: 95% or more) having an average grain size of 5 µm or less were measured so that the mole ratio is 1 : 2 at the stoichiometric composition, they were mixed in an argon atmosphere for 5 hours by using a planetary ball mill. A container when mixing them and the ball of the planetary ball mill were made of ZrO₂. The obtained powder was filled in an copper/iron compound pipe mechanically integrated beforehand (having an outer diameter of 20 mm, an inner diameter of 16 mm, and a length of 500 mm). After filling, wire drawing was repeated so that cross section reduction ratio per one pass was within the range of 8 % to 12 %, the wire drawing was performed until the diameter of the wire became 2.0 mm, and the single-core wire 2 was produced. Incidentally, a process annealing was suitably performed as necessary in the wire drawing pass schedule.

Besides, it is explained about the in-situ method as a main example in one embodiment, but in the case of applying ex-situ method or premix method, the single-core wire is produced depending on their optimal condition. Also, a raw material powder may be refined to nanometer size to increase the workability and the superconducting property of MgB₂ superconductor.

### <Twisting process>

In the twisting process, seven single-core wires 2 produced as described above is used, and the multi-core wire 1 is formed by twisting together seven single-core wires 2 at the twist pitch of 10 mm to 100 mm. It is important to provide the gap at portions where the single-core wires are in contact with each other and to form the refrigerant duct in order to increase the cooling efficiency. Actually, compared with the multi-core wire (comparative material) produced by the multi-core embedding procedure that nineteen MgB₂ single-core wires are inserted in a copper pipe in which nineteen circular holes are made beforehand to obtain the cross section as illustrated in FIG. 5, It is confirmed by the experiment later that the cooling efficiency in case of using liquid helium, liquid hydrogen, or liquid neon as the refrigerant is improved by 30% or greater. Incidentally, a stabilized metal whose electric resistance is low may be disposed instead of the single-core wire. Also, a high strength wire may be disposed if mechanical strength is required.

It is necessary that the final diameter of the single-core wire 2 is 0.5 mm or less, and the single-core wire 2 is covered with the metal pipe in which copper, aluminum, iron, niobium, tantalum, or nickel is used alone or included as a principal component, additionally the outer surface of the wire is covered with copper or copper alloy. The conductor, in which the uniformity of the shape and the uniformity of electrical characteristic in each superconducting core part 3 are high, is obtained by using the single-core wire 2 having such a configuration.

### Example 2

Also, the same effect can be achieved that as illustrated in the cross section schematic diagram of FIG. 4, the same gap 6 is formed by twisting a plurality of the single-core wires 2 with the wire of stabilized metal 7 which is made of copper, iron, or the like in the stranding process, in the case that there is no stabilization phase 5 in the cross section of the single-core wires 2.

### Example 3

A superconducting cable is obtained by performing a heat treatment for superconducting to a plurality of the multi-core wires 1, wrapping the whole with an aluminum plate, and jointing the place in which the edge of the aluminum plate is wrapped. The cooling efficiency is increased by flowing of the refrigerant inside the cable too, because each superconducting cable is thick. Also, highly efficient superconducting cable and superconducting magnet which is used in MRI ,NMR, or the like can be realized by using the multi-core wire 1 alone or a plurality of the multi-core wires 1 which is bound as the wire for the superconducting magnet.

FIG. 6 illustrates a main structure of a superconducting magnet 14. The superconducting magnet 14 is worked in the persistent current mode that a closed circuit is formed by only superconductor and current continuously flows. A superconducting coil 8 and a persistent current switch 9 are connected in a superconducting joint 10. The superconducting coil 8, the persistent current switch 9, and a current lead 11 are fixed to a support plate 12, these devices are disposed in a cooling vessel 13, and one end of the current lead 11 is connected to an external equipment (not shown).

In case of exciting the superconducting coil 8, the persistent current switch 9 is set to an off-state by heating and current is supplied from the current lead 11. After the completion of excitation, if the persistent current switch 9 is set to an on-state by stopping heat and current which is supplied from the current lead 11 becomes zero, the superconducting magnet 14 is worked in the persistent current mode that current continuously flows in the closed circuit consist of the superconducting coil 8 and the persistent current switch 9. FIG. 6 illustrates one superconducting magnet, but generally magnet is configured to a plurality of the coils and they are connected in series, so the numbers of the superconducting joint 10 increase according to the number of the coil.

Besides, in this case, the multi-core wire is wrapped by an aluminum plate, but the same effect can be achieved in the case of producing by inserting to the metal pipe which is stainless pipe or the like.

### [Description of Reference Numerals]

- 1: multi-core wire
- 2: single-core wire
- 3: superconducting core part
- 4: barrier phase
- 5: stabilization phase
- 6: gap (refrigerant duct)
- 7: stabilized metal
- 8: superconducting coil
- 9: persistent current switch
- 10: superconducting joint
- 11: current lead
- 12: support plate
- 13: cooling vessel
- 14: superconducting magnet

## Claims

1. A MgB₂ multi-core wire (1) comprising a plurality of MgB₂ single-core wires (2) having a MgB₂ superconducting core part (3) and a metal sheath part,
the metal sheath part being provided on the outer surface of the MgB₂ superconducting core part (3), wherein
a plurality of the MgB₂ single-core wires (2) is bound with each other, and
a gap (6) is provided between wires of the plurality of MgB₂ single-core wires (2), and
a refrigerant is flown in the gap (6) in a direction of a longitudinal axis of the MgB₂ single-core wires (2).

2. The MgB₂ multi-core wire according to claim 1, wherein
the metal sheath part comprises a barrier phase (4) and a stabilization phase (5),
the barrier phase (4) includes at least one of copper, aluminum, iron, niobium, tantalum, and nickel, and
the stabilization phase (5) includes copper.

3. The MgB₂ multi-core wire according to claim 1, wherein
the refrigerant is selected from a group consisting of liquid helium, liquid hydrogen, and liquid neon.

4. The MgB₂ multi-core wire according to claim 2, wherein
the diameter of the MgB₂ single-core wire (2) is 0.5 mm or less.

5. A superconducting cable comprising:
a plurality of the MgB₂ multi-core wires (2) according to claim 1, wherein
wires of the plurality of MgB₂ multi-core wires (2) are bound to each other.

6. A superconducting magnet comprising
a superconducting coil, and
a persistent current switch,
the superconducting coil being connected to the persistent current switch, wherein
a MgB₂ multi-core wire according to claim 1 is used to form the superconducting coil, and
a MgB₂ multi -core wire according to claim 1 is used to form the persistent current switch.
